# EUROPEAN PATENT APPLICATION

(11) **EP 0 924 773 A1**
(43) Date of publication of application: **23.06.1999**
(21) Application number: 98123767.0
(22) Date of filing: 14.12.1998
(51) Int. Cl.: H01L 29/786, H01L 29/45, H01L 29/04, H01L 27/12, H01L 21/336, H01L 21/84, H01L 21/265

(54) **Semiconductor device including a SOI MOSFET having source and drain electrodes comprising a metal silicide layer and method of making the same**

(30) Priority: 15.12.1997 JP 36249897
(71) Applicant: NEC CORPORATION, Tokyo (JP)
(72) Inventor: Onishi, Hideaki, Minato-ku, Tokyo (JP)
(74) Representative: Glawe, Delfs, Moll & Partner

(57) **Abstract**

A semiconductor device including an SOI MOS field-effect transistor comprising a silicon substrate (1), a thin insulation film (2) formed on the substrate and a thin silicon film (4,5,10,11,12,15) formed on the insulation film. The MOS transistor has a channel region (4,5) of first conductivity type and source and drain regions (10,11) of second conductivity type, a layer of metal silicide having a high melting point (14) adjoining a part of the source and drain regions. A polysilicon layer (12,15) forms the portion of the thin silicon film located between the metal silicide and the insulation film. Since polysilicon promotes silicidation, low resistance silicide source and drain contacts can be achieved, even if the contact width is decreased, thereby avoiding a narrow line effect. Furthermore, the Kink effect can be reduced since polysilicon acts as a minority carrier recombining layer. The present structure is particularly suitable for N-channel MOSFETs. However it is also suitable for P-channel MOSFETs and can be applied to both transistors in an SOI CMOS device. A manufacturing method involving amorphization of a monocrystalline silicon thin film by arsenic implantation and subsequent RTA to form the polysilicon layer is moreover disclosed.

## Description

### BACKGROUND OF THE INVENTION

The present invention relates to a semiconductor device and more particularly to an SOI (Silicon-On-Insulator) semiconductor device.

SOI devices are attracting increasing attention because they facilitate the isolation of devices, have a latch-up free feature, and can reduce source/drain junction capacitance. However, when a MOS (Metal Oxide Semiconductor) device is formed on an SOI film as thin as 100 nm or less, source/drain resistance noticeably increases. In this case, a technique for reducing source/drain resistance is essential. A silicide technique using titanium or similar metal having a high melting point is the predominant technique available for the above purpose.

The general configuration of a semiconductor device having titanium silicide formed on a MOS device provided on a thin SOI film is taught in Proceedings 1995 IEEE International SOI conference, Oct, 1995. The problem with the configuration disclosed in this document is that when silicide is to be formed on a source/drain held in its single crystal Si state, phosphorus and arsenic that are dopants suppress silicidation, particularly in an NMOS. As a result, the resistance of the silicide sharply increases with a decrease in the line width of the source/drain. Let this effect be referred to as a narrow line effect. Such an increase in silicide resistance has critical influence on the operation speed when it comes to LSIs (Large Scale Integrated circuits) of half-micron generation and successive generations.

Technologies relating to the present invention are also disclosed in, e.g., Japanese Patent Laid-Open Publication No. 6-140428 and "A TI-SALICIDE PROCESS UTILIZING LOW PRESSURE N₂ RTA" by Ishigami et al, June 27-29, 1995 VMIC Conference, 1995 ISMIC-104/95/0640.

### SUMMARY OF THE INVENTION

It is therefore an object of the present invention to provide an SOI semiconductor device capable of suppressing an increase in silicide resistance on the source/drain of an SOI device ascribable to the narrow line effect without complicating the structure or adversely effecting the characteristics.

A semiconductor device of the present invention includes an SOI substrate having a superficial thin insulation film, and a MOS transistor formed on the SOI substrate. The MOS transistor has a first conductivity type channel region, a second conductivity type source/drain region diffused to the thin insulation film, metal silicide having a high melting point covering a part of the source/drain region, and a polysilicon layer formed between the metal silicide and the thin insulation film.

### BRIEF DESCRIPTION OF THE DRAWINGS

The above and other objects, features and advantages of the present invention will become more apparent from the following detailed description taken with the accompanying drawings in which:
FIG. 1 is a section showing a conventional semiconductor device;

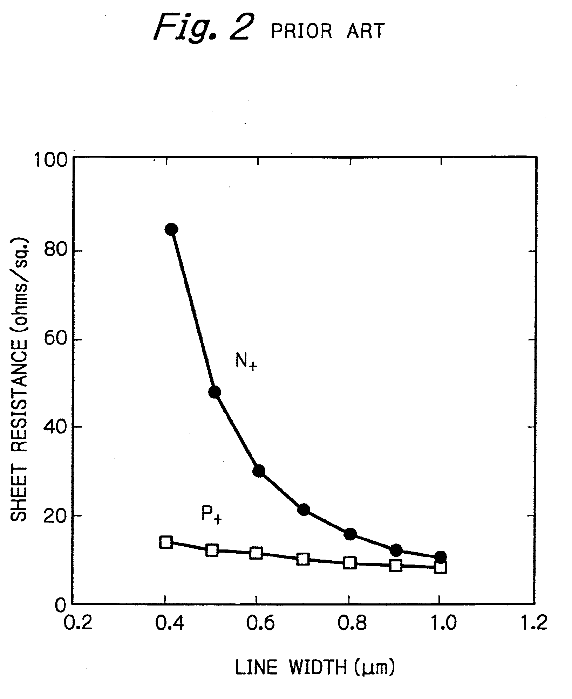

FIG. 2 is a graph showing a narrow line effect particular to the conventional semiconductor device;
FIG. 3 is a section showing a CMOS (Complementary MOS) device embodying the present invention;
FIG. 4 is a graph showing a narrow line effect particular to the illustrative embodiment;
FIGS. 5A-5F are sections showing a sequence of steps for producing the CMOS device of the illustrative embodiment; and
FIG. 6 is a section showing an alternative embodiment of the present invention.

In the drawings, identical reference numerals denote identical structural elements.

### DESCRIPTION OF THE PREFERRED EMBODIMENTS

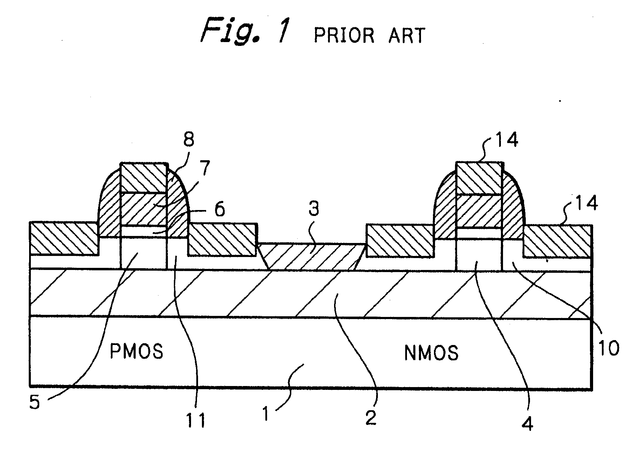

To better understand the present invention, brief reference will be made to a conventional semiconductor device in which a Ti (titanium) silicide is formed on a MOS device provided on a thin SOI film, shown in FIG. 1. This kind of semiconductor device is taught in Proceedings 1995 IEEE International SOI conference, Oct, 1995 mentioned earlier. As shown, the semiconductor device is made up of an Si (silicon) substrate 1, a buried oxide film 2, a field oxide film 3, a P layer 4 constituting the channel portion of an NMOS, an N layer 5 constituting the channel portion of a PMOS, an N+ layer constituting the source/drain of the NMOS, and a P+ layer 11 constituting the source/drain of the PMOS. There are also shown in FIG. 1 a gate oxide layer 6, a poly gate 7, a sidewall 8, and a Ti silicide (TiSi₂).

Generally, the N+ layer 10 and P+ layer each is so formed as to remain in a single crystal Si layer in order to obviate junction leak and other problems. As for the injection of the source/drain of NMOS, in particular, it is generally accepted that phosphorus should preferably be used in order to prevent the source/drain from becoming entirely amorphous.

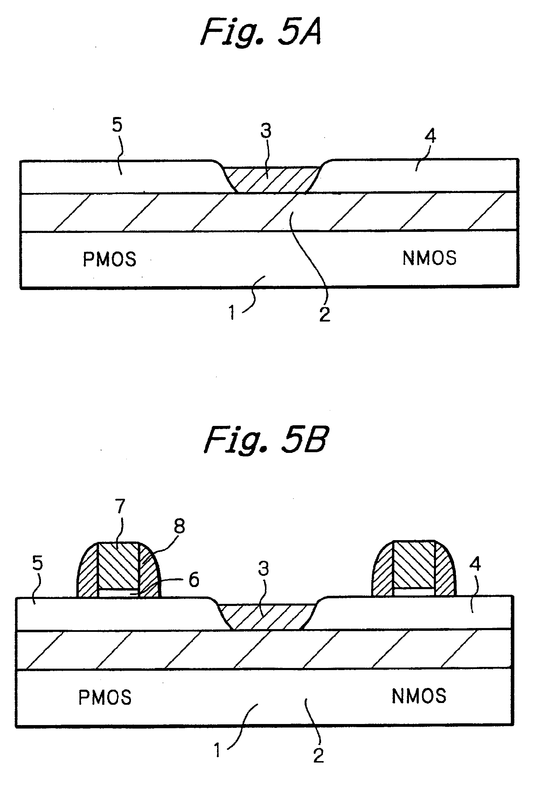

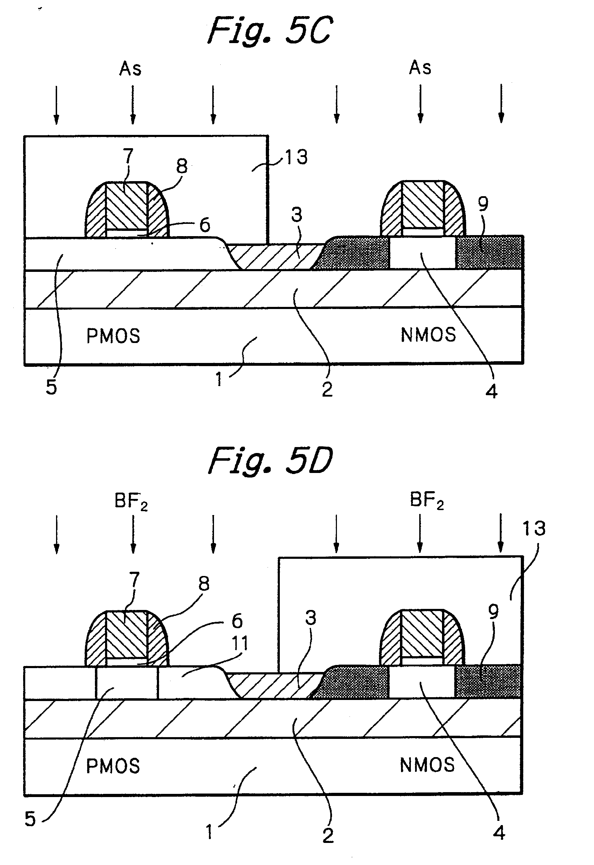

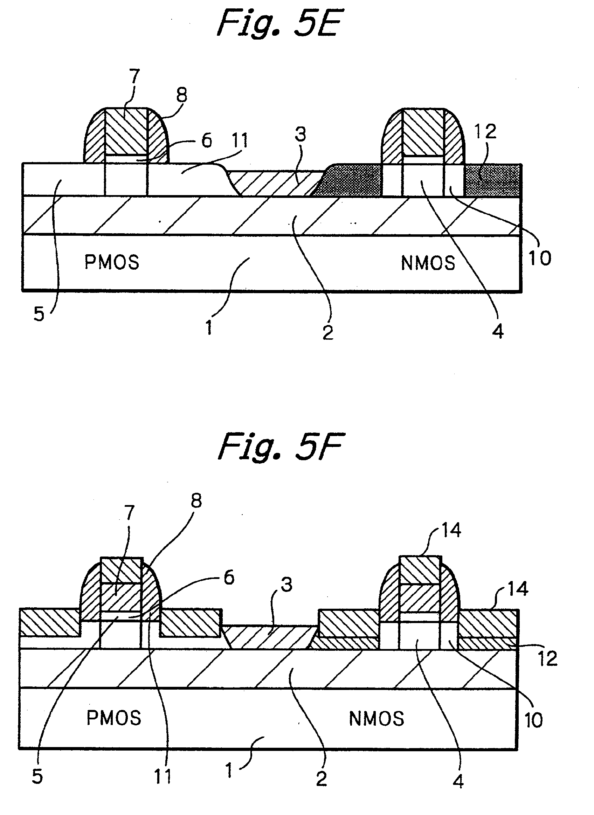

The problem with the above general configuration is that when silicide is to be formed on a source/drain held in its single crystal Si state, phosphorus and arsenic that are dopants suppress silicidation, particularly in an NMOS. As a result, as shown in FIG. 5, the resistance of the silicide sharply increases with a decrease in the line width of the source/drain. Let this effect be referred to as a narrow line effect. Such an increase in silicide resistance has critical influence on the operation rate when it comes to LSIs of half-micron generation and successive generations.

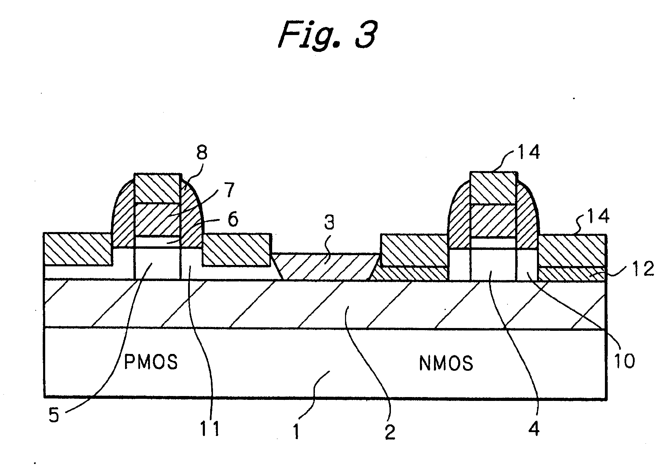

Referring to FIG. 3, a semiconductor device embodying the present invention will be described. As shown, the semiconductor devise includes an N+ poly-Si layer 12 and TiSi₂ 14 formed on the N+ poly-Si layer 12. The N+ poly-Si layer 12 is positioned in a region where the Ti silicide of the source/drain of an NMOS is expected be formed.

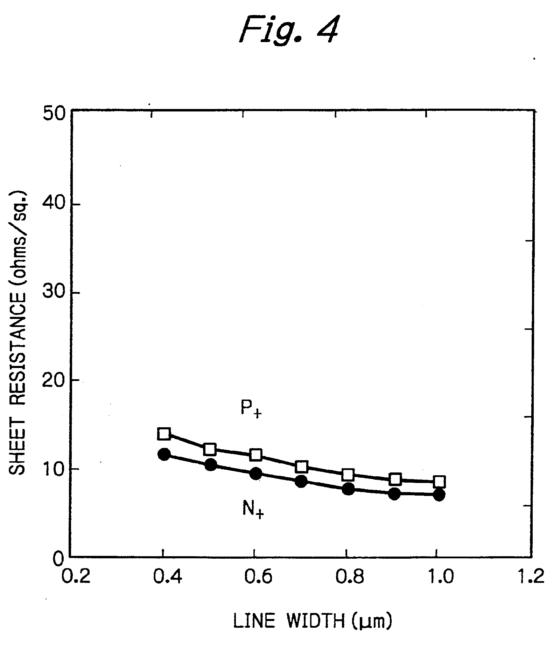

In the region of the NMOS where the silicide is to be formed, the N+ poly-Si layer 12 constitutes an N+ layer. Poly-Si differs from single crystal Si in that grain boundaries are present and promote cilicidation due to diffusion. This successfully suppresses the conventional decrease of line width. As a result, as shown in FIG. 4, low resistance silicide can be formed even when the line width is of the order of half micron. In addition, in the illustrative embodiment, an N+ layer 10 adjoining the channel region is held in a single crystal state, obviating the influence of junction leak and other occurrences on the device characteristics.

Generally, the problem with an SOI transistor is that a hole generated by a drain electric field during operation raises the potential of a channel portion. The raised potential is apt to bring about a parasitic bipolar effect, e. g., a kink in the drain current to drain voltage characteristic of the transistor and a decrease in drain voltage. By contrast, in the structure shown in FIG. 3, the silicon portion beneath the silicide of the source serves as the center of rebonding of a hole generated in the drain electric field and thereby promotes the efficient absorption of a hole. Consequently, the illustrative embodiment is capable of suppressing the parasitic bipolar effect.

Reference will be made to FIGS. 5A-5F for describing a specific sequence of steps for producing the semiconductor device of FIG. 3. First, as shown in FIG. 5A, an Si layer included in an SOI substrate 1 is thinned to a desired thickness, e.g., 50 nm. Then, a field oxide layer 3 is formed by LOCOS (Local Oxidation of Silicon) or similar conventional method in order to isolate devices. Subsequently, boron and phosphorus are respectively implanted to a concentration of about 1,017 cm⁻³ to 1,018 cm⁻³. For the implantation, photoresist is used as a mask. As a result, a P- layer and an N-layer 5 are formed.

As shown in FIG. 5B, a gate oxide film that is, e.g., 7 nm thick is formed by thermal oxidation. Then, poly-Si is deposited on the gate oxide film by CVD (Chemical Vapor Deposition) to a thickness of, e.g., 150 nm. The poly-Si is subjected to photo lithography and anisotropic etching in order to form a poly gate 7. Subsequently, an oxide film that is, e. g., 100 nm thick is formed by CVD and then etched by in order to form a sidewall.

As shown in FIG. 5C, photoresist 13 for forming the source/drain of the NMOS is patterned. Then, arsenic or similar dopant easy to form an amorphous layer by ion implantation and having a great mass is implanted to a concentration of about 5 x 1,020 cm⁻³ by the energy of about 50 kev. Consequently, an amorphous layer 9 doped to the N type with a high concentration is formed.

As shown in FIG. 5D, after photoresist 13 for forming the PMOS has been patterned, BF2, for example, is implanted to a concentration of about 5 x 1,020 cm⁻³ by the energy of 30 kev.

As shown in FIG. 5E, RTA is effected at, e.g., 1,000° for 10 seconds for the activation of the impurities. As a result, in the NMOS, the amorphous layer forms the N+ poly-Si layer 12. Also, in the NMOS, the portion contacting the P- layer 4 of the channel forms the N+ layer 10 (single crystal Si layer) due to the horizontal diffusion of the dopant and the solid layer epitaxial growth from the single crystal Si layer of the channel portion. In the PMOS, the entire source/drain region forms the P+ layer 11 (single crystal layer) due to the absence of an amorphous layer.

As shown in FIG. 5F, TiSi₂ 14 is formed on the source/drain and poly gate by a conventional method. To form Ti silicide, there may be used the steps of sputtering Ti to a thickness of 20 nm, effecting RTA at 700°C in a nitrogen atmosphere for forming TiSi2 of C49 phase, selectively etching the resulting TiN forming an insulation film by using, e. g. , an NH₄OH, H₂O₂ and H₂O solution, and forming low resistance TiSi₂ 14 of C54 phase by RTA effected at 800°C in a nitrogen atmosphere.

After the step shown in FIG. 5F, a wiring is formed by a conventional method.

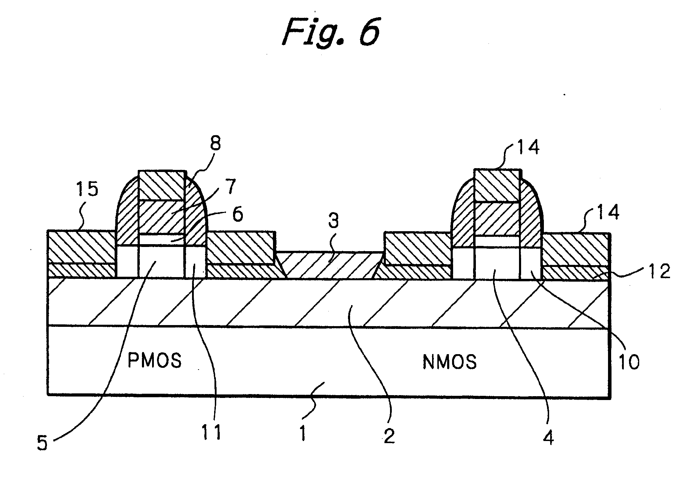

FIG. 6 shows an alternative embodiment of the present invention. As shown, this embodiment is essentially similar to the previous embodiment except that the P+ layer in the silicide forming region of the PMOS is implemented by a P+ poly-Si layer 15. Specifically, in the step of FIG. 5B, arsenic, for example, is implanted to a concentration of about 1 x 1,020 cm⁻³ by the energy of -50 kev without using a mask. As a result, the source/drain regions of the NMOS and PMOS become amorphous. This is followed by the same steps as in the previous embodiment.

It is to be noted that arsenic implanted in the PMOS of FIG. 6 is repulsed by BF2 used to form the source/drain. Although the PMOS is originally lower in thin line effect than the NMOS and therefore does not decrease in resistance as noticeably as the NMOS, silicide further lower in resistance is achievable by the additional ion implantation.

While the illustrative embodiments have concentrated on Ti silicide, the present invention is also practicable with cobalt, nickel or similar metal silicide having a high melting point.

In summary, it will be seen that the present invention provides a semiconductor device having various unprecedented advantages, as enumerated below.
(1) Because silicide is formed on poly-Si low resistance silicide with a suppressed narrow line effect can be formed even on a thin SOI film.
(2) The source/drain of a thin SOI film device can be reduced in resistance without resorting to a sophisticated structure or procedure.
(3) The portion of the source/drain region contacting a channel portion is held in a single crystal state, so that device characteristics are not susceptible to junction leak and other occurrences.
(4) There can be suppressed the parasitic bipolar effect of an SOI transistor.

Various modifications will become possible for those skilled in the art after receiving the teachings of the present disclosure without departing from the scope thereof.

## Claims

1. A semiconductor device comprising:
an SOI (Silicon-On-Insulator) substrate having a superficial thin insulation film; and
a MOS (Metal Oxide Semiconductor) transistor formed on said SOI substrate;
said MOS transistor comprising:
a first conductivity type channel region;
a second conductivity type source/drain region diffused to said thin insulation film;
metal silicide having a high melting point covering a part of said source/drain region; and
a polysilicon layer intervening between said metal silicide and said thin insulation film.

2. A semiconductor device as claimed in claim 1, wherein said SOI substrate comprises a silicon substrate, said thin insulation film formed on said silicon substrate, and a thin silicon film formed on said thin insulation film.

3. A semiconductor device as claimed in claim 2, wherein said polysilicon layer is formed by ion implantation and high temperature annealing.

4. A semiconductor device as claimed in claim 3, wherein said MOS transistor comprises a PMOS transistor and an NMOS transistor.

5. A semiconductor device as claimed in claim 4, wherein said polysilicon layer is formed only in a device region of said NMOS transistor.

6. A semiconductor device as claimed in claim 2, wherein a part of said thin silicon film formed on said thin insulation film is transformed to said metal silicide and said polysilicon layer.

7. A semiconductor device as claimed in claim 1, wherein said polysilicon layer is formed by ion implantation and high temperature annealing.

8. A semiconductor device as claimed in claim 7, wherein said MOS transistor comprises a PMOS transistor and an NMOS transistor.

9. A semiconductor device as claimed in claim 8, wherein said polysilicon layer is formed only in a device region of said NMOS transistor.

10. A semiconductor device as claimed in claim 1, wherein said MOS transistor comprises a PMOS transistor and an NMOS transistor.

11. A semiconductor device as claimed in claim 10, wherein said polysilicon layer is formed only in a device region of said NMOS transistor.

12. A semiconductor device as claimed in claim 1, wherein said polysilicon layer is formed only in a device region of said NMOS transistor.

13. A semiconductor device as claimed in claim 1, wherein a part of said thin silicon film formed on said thin insulation film is transformed to said metal silicide and said polysilicon layer.

14. A semiconductor device as claimed in claim 1, further comprising a single crystal silicon layer formed between said polysilicon layer and said channel region of said transistor.
